(19) Europäisches Patentamt
European Patent Office
Office européen des brevets

(11) **EP 3 579 060 B1**

(12) **FASCICULE DE BREVET EUROPEEN**

(45) Date de publication et mention
de la délivrance du brevet:
**18.10.2023 Bulletin 2023/42**

(21) Numéro de dépôt: **19173616.4**

(22) Date de dépôt: **09.05.2019**

(51) Classification Internationale des Brevets (IPC):
**G04C 10/00** *(2006.01)*

(52) Classification Coopérative des Brevets (CPC):
**G04C 10/00**

(54) **MONTRE THERMOÉLECTRIQUE**

THERMOELEKTRISCHE UHR

THERMOELECTRIC WATCH

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **05.06.2018 EP 18175994**

(43) Date de publication de la demande:
**11.12.2019 Bulletin 2019/50**

(73) Titulaire: **The Swatch Group Research and
Development Ltd
2074 Marin (CH)**

(72) Inventeurs:
• **JORNOD, Alain
2000 Neuchâtel (CH)**
• **GUEISSAZ, François
2036 Cormondrèche (CH)**
• **FERRI, Yvan
2024 St-Aubin-Sauges (CH)**

(74) Mandataire: **ICB SA
Faubourg de l'Hôpital, 3
2001 Neuchâtel (CH)**

(56) Documents cités:
EP-A1- 1 001 318     EP-A1- 1 043 781
FR-A1- 2 310 589     US-A- 5 889 735
US-A1- 2003 007 424     US-B1- 6 222 114
US-B1- 6 316 714

# Description

## Domaine de l'invention

L'invention se rapporte au domaine technique des montres dotées d'un générateur thermoélectrique, dites montres thermoélectriques.

## Arrière-plan de l'invention

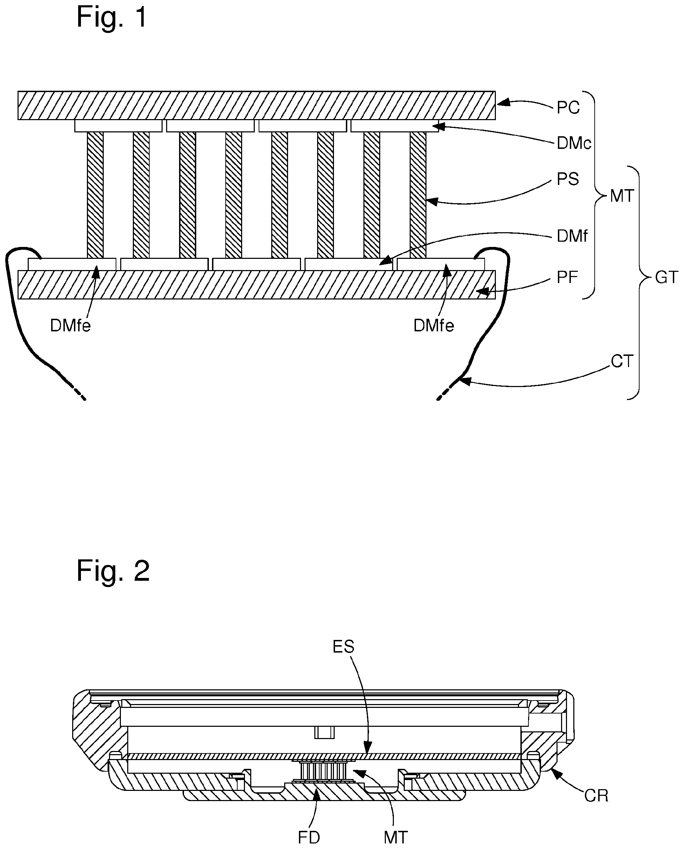

Un tel générateur thermoélectrique permet la transformation d'un flux thermique en une puissance électrique utilisable pour faire fonctionner un dispositif électrique de la montre (mouvement de la montre, dispositif d'éclairage du cadran, etc.). En référence à la figure 1, un générateur thermoélectrique GT comporte classiquement un module thermoélectrique MT et un circuit électrique de transmission CT. Le module thermoélectrique MT comprend une plaque dite froide PF et une plaque dite chaude PC, électriquement isolantes, sensiblement parallèles l'une à l'autre et portant chacune des dominos DMf, DMc électriquement conducteurs disposés les uns à côté des autres. Le module thermoélectrique MT comporte également des piliers semi-conducteurs PS s'étendant entre les dominos DMc de la plaque chaude PC et les dominos DMf de la plaque froide PF. Les piliers PS sont positionnés de sorte que chaque domino DMc de la plaque chaude PC est relié à deux dominos DMf de la plaque froide PF par un couple de piliers PS semi-conducteurs formé d'un pilier à semi-conducteur dopé n et d'un pilier à semi-conducteur dopé p, et chaque domino DMf de la plaque froide PF excepté les deux extrémaux DMfe est relié à deux dominos DMc de la plaque chaude PC. Ainsi, les piliers PS sont reliés électriquement en série et thermiquement en parallèle. Enfin, le circuit électrique de transmission CT relie les deux dominos extrémaux DMfe de la plaque froide PF au dispositif électrique à alimenter.

De manière classique, la plaque chaude est thermiquement en série avec le fond de la montre, et la plaque froide est thermiquement en série avec la carrure. Lorsque la plaque chaude est échauffée par transmission de la chaleur naturelle dégagée par le poignet du porteur de la montre, il se produit une différence de température entre la plaque chaude et la plaque froide. Le gradient de température est à l'origine d'une différence de potentiel électrique via l'effet Seebeck entre les dominos de la première plaque et les dominos de la deuxième plaque. Cette différence de potentiel électrique est ensuite communiquée au dispositif électrique à alimenter via le circuit électrique de transmission. On note que le circuit électrique de transmission comporte avantageusement un élévateur de tension de sorte que le générateur thermoélectrique puisse alimenter le dispositif électrique même lorsque les flux thermiques sont faibles.

Pour maximiser le gradient de température, le module thermoélectrique doit être mis en contact thermique de manière optimale avec le fond d'une part, et avec la carrure d'autre part. En référence à la figure 2, ce contact thermique optimal se traduit classiquement par le maintien d'une pression entre le fond FD et le module thermoélectrique MT d'une part, et entre le module thermoélectrique MT et une plaque de support ES reliée thermiquement et mécaniquement à la carrure CR d'autre part. Cependant, avec un tel système, des chocs sur la carrure CR se propagent facilement au module thermoélectrique MT, pouvant entraîner une détérioration du module thermoélectrique MT dont les plaques chaude et froide PC, PF sont fragiles.

Dans l'art antérieur on connaît aussi les document EP1043781A1 et

US2003007424A1 lesquels divulguent des montres thermoélectriques selon le préambule de la revendication 1 annexée.

## Résumé de l'invention

Pour résoudre ce problème, il est proposé une montre selon la revendication 1.

Ainsi, il est proposé de doter l'élément de support d'au moins deux branches ayant une extrémité commune au niveau de laquelle s'effectue le contact thermique avec la plaque froide du module thermoélectrique, les autres extrémités des branches - dites secondes extrémités - étant destinées à être solidaires de la carrure. Grâce aux branches flexibles, l'élément de support joue un rôle d'amortisseur de chocs, de sorte à éviter qu'un choc sur la carrure ne se propage au module thermoélectrique. L'élément de support joue donc le double rôle de conducteur thermique et de ressort mécanique à raideur contrôlée. La raideur variant selon le produit $ab^3$, et la conductance thermique variant selon le produit $ab$, où $a$ et $b$ sont respectivement la largeur et l'épaisseur des branches, il est possible d'optimiser les paramètres thermiques et mécaniques de l'élément de support en choisissant judicieusement les dimensions $a$ et $b$ des branches.

En outre, l'invention peut comporter les caractéristiques définies dans les revendications dépendantes.

Dans un mode de réalisation, l'élément de support comporte un anneau métallique passant par les deuxièmes extrémités des branches, et l'anneau est fixé à la carrure de sorte que les deuxièmes extrémités sont solidaires de la carrure par l'intermédiaire de l'anneau. On optimise ainsi la fixation de l'élément de support à la carrure. L'anneau de l'élément de support est par exemple chassé ou/et collé sur la carrure.

L'élément de support peut être monobloc ou non. Les branches peuvent être de même longueur ou non, de sorte à centrer ou décentrer le module thermoélectrique par rapport à la carrure. L'élément de support peut être fait d'un seul matériau (aluminium, cuivre, Cu-Be, etc.) ou d'un assemblage de matériaux (dont le graphite par exemple, qui a une forte conductibilité thermique).

Dans un mode de réalisation, un coussinet à grande conductibilité thermique et fort pouvoir amortisseur mécanique est placé à l'interface entre le fond et le module thermoélectrique. Dans un mode de réalisation qui peut être combiné à celui évoqué à la phrase précédente, un coussinet à grande conductibilité thermique et fort pouvoir amortisseur mécanique est placé à l'interface entre le module thermoélectrique et l'élément de support. Les coussinets peuvent être formés d'élastomère chargé avec du verre.

Dans un mode de réalisation, le fond comporte :

- une partie en matériau conducteur (par exemple en aluminium, CuBe, etc.) agencée de sorte à être en contact avec le poignet lorsque la montre est portée et à diriger le flux thermique vers le module thermoélectrique. Avantageusement, côté poignet, la surface de la partie conductrice couvre la majorité de la surface totale du fond, mais du côté module thermoélectrique (c'est-à-dire le côté opposé au côté poignet), la surface de la partie conductrice est à peine plus grande que la surface de la plaque chaude : ainsi la surface de prélèvement du flux thermique est grande mais le flux est ensuite concentré vers le module thermoélectrique uniquement.

- une partie en matériau isolant (par exemple en ABS, polyamide, etc.) agencée de sorte à diminuer le flux thermique passant directement du fond de la montre vers la carrure sans passer par le module thermoélectrique. La zone périphérique de la partie isolante est destinée à être fixée à la carrure ; la zone centrale de la partie isolante est recouverte par la partie conductrice côté poignet.

Les parties conductrice et isolante peuvent prendre des formes variées pour optimiser les fonctions conductrices et isolantes et pour créer des effets décoratifs. La partie conductrice et la partie isolante peuvent être assemblées au moyen de circlips du côté module thermoélectrique, d'un sertissage, de colle, etc.

Dans un mode de réalisation, la partie isolante est creusée côté module thermoélectrique pour réduire son épaisseur. Plus précisément, la zone centrale de la partie isolante est d'épaisseur plus faible que la zone périphérique de la partie isolante. La raison en est que l'air est meilleur isolant thermique que n'importe quel matériau qui pourrait constituer la partie isolante (car avec des dimensions aussi faibles, les phénomènes de convexion de l'air ne se produisent pas). On pourrait d'ailleurs envisager de remplacer l'air par un autre gaz plus isolant (par exemple de l'argon, du CO2, ou de l'hexafluorure de soufre SF6).

De même, la platine qui supporte les composants auxquels le générateur thermoélectrique est relié est éventuellement creusée pour augmenter le volume d'air (ou de gaz) et ainsi améliorer l'isolation thermique entre le fond de la montre et les éléments internes de la montre.

Dans un mode de réalisation, pour renforcer la partie isolante dont l'épaisseur peut être faible pour les raisons mentionnées précédemment, la partie conductrice côté poignet ou la partie isolante côté module thermoélectrique comporte des bras rigides. Les bras peuvent être faits d'un matériau identique ou différent des parties conductrice et isolante.

Dans un mode de réalisation, un disque jouant le rôle d'écran radiatif thermique est disposé sur la zone centrale de la partie isolante côté module thermoélectrique, pour améliorer l'isolation thermique en évitant les échanges thermiques par radiation. Le matériau utilisé comme écran peut être un matériau à faible émissivité thermique à température ambiante, comme de l'aluminium déposé par spray, évaporation, peinture, etc. Le disque radiatif peut alternativement être fabriqué à partir de matériaux déposés en plusieurs couches sur un film de type PET ou autre, comme des couvertures de survie, puis rapporté sur le fond, côté doré contre le fond. On note que le disque joue également le rôle de cage de Faraday, protégeant la montre contre d'éventuelles décharges électrostatiques.

Dans un mode de réalisation, la raideur mécanique K de l'élément de support est compris dans un intervalle allant de 0.15 N/mm à 2800 N/mm, de préférence allant de 12.8 N/mm à 104.8 N/mm.

Dans un mode de réalisation, la conductance thermique C de l'élément de support est compris dans un intervalle allant de 6.7 à 840 mW/K, de préférence allant de 47 et 198 mW/K.

Dans un mode de réalisation, l'élément de support comprend des films à base de graphite collés sur les branches, les films présentant de préférence des conductibilités thermiques d'au moins 400 W/m/K. Les films augmentent la conductance thermique des branches.

Dans un mode de réalisation, les au moins deux branches sont en aluminium.

Description sommaire des dessins

D'autres particularités et avantages ressortiront clairement de la description qui en est faite ci-après, à titre indicatif et nullement limitatif, en référence aux dessins annexés, dans lesquels :

- la figure 1, déjà décrite, représente un générateur thermoélectrique pouvant être utilisé pour fournir de l'énergie électrique à une montre,

- la figure 2, déjà décrite, représente un module du générateur thermoélectrique de la figure 1, installé au niveau du fond d'une montre,

- la figure 3 est une vue semi-éclatée d'une montre thermoélectrique selon un mode de réalisation de l'invention,

- la figure 4 représente une carrure et un élément de support d'un module thermoélectrique, d'une montre thermoélectrique selon un mode de réalisation de l'invention,

- la figure 5 représente une montre thermoélectrique selon un mode de réalisation de l'invention, vue côté fond, fond retiré,

- la figure 6 représente un fond d'une montre thermoélectrique selon un mode de réalisation de l'invention, vue côté poignet,

- la figure 7 représente un fond d'une montre thermoélectrique selon un mode de réalisation de l'invention, vue côté module thermoélectrique,

- la figure 8 représente un fond d'une montre thermoélectrique selon un mode de réalisation de l'invention, vue côté poignet,

- la figure 9 représente un fond d'une montre thermoélectrique selon un mode de réalisation de l'invention, vue côté module thermoélectrique,

- la figure 10 représente une montre thermoélectrique selon un mode de réalisation de l'invention, vue côté fond, fond retiré,

- la figure 11 représente un fond d'une montre thermoélectrique selon un mode de réalisation de l'invention, vue côté module thermoélectrique, surmonté d'un écran thermique radiatif.

Description détaillée des modes de réalisation préférés

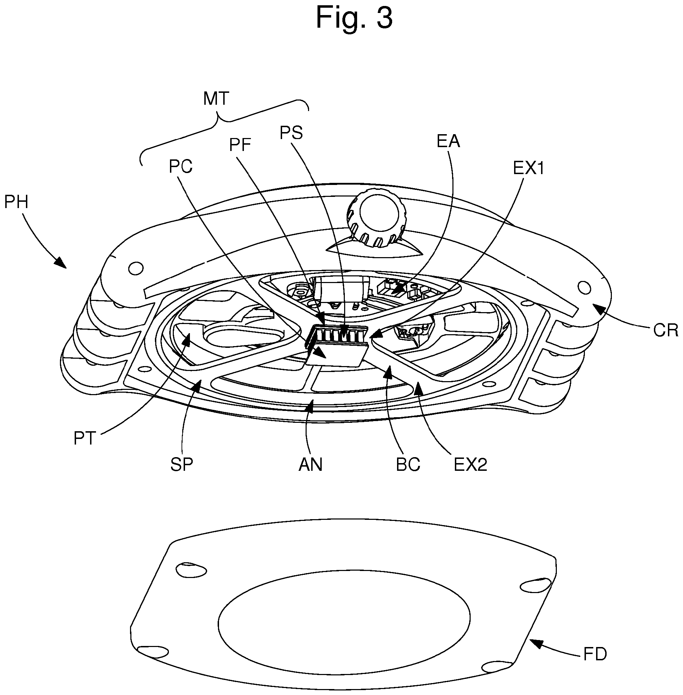

La figure 3 est une vue éclatée d'éléments d'une montre PH thermoélectrique selon un mode de réalisation de l'invention. La montre PH comporte :

- une carrure CR

- une platine PT installée dans la carrure CR

- des éléments EA à alimenter en énergie électrique supportés par la platine PT

- un fond FD fixé à la carrure CR

- un générateur thermoélectrique comportant un module thermoélectrique MT, ledit module MT comportant une plaque dite chaude PC, une plaque dite froide PF, et des piliers semi-conducteurs PS s'étendant entre la plaque chaude PC et la plaque froide PF

- un élément de support SP connecté mécaniquement à la carrure CR, entre le fond FD et la platine PT, le module thermoélectrique MT étant disposé entre l'élément de support SP et le fond FD.

L'élément de support SP joue un double rôle d'amortisseur (protégeant le module thermoélectrique d'éventuels chocs) et de moyen d'évacuation de chaleur vers la carrure CR.

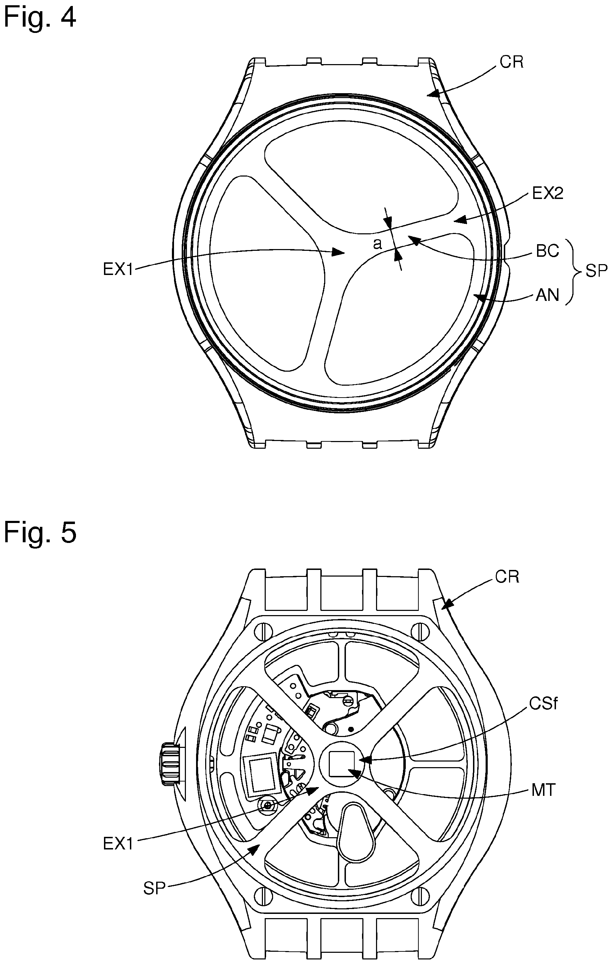

L'élément de support SP est formé d'un anneau AN et d'une pluralité de branches BC s'étendant les unes vers les autres depuis l'anneau AN. Ainsi, les branches BC comportent une extrémité commune EX1 (au centre de l'anneau dans le cas où les branches sont toutes sensiblement de même longueur, décentrée par rapport à l'anneau sinon). Les autres extrémités des branches, dites deuxièmes extrémités EX2, sont connectées à l'anneau AN. Ledit anneau AN est fixé à la carrure CR ; l'anneau AN est par exemple chassé ou/et collé ou/et vissé ou/et clipsé sur la carrure CR. On pourrait alternativement imaginer que l'élément de support SP ne comporte pas d'anneau AN, et que les deuxièmes extrémités EX2 des branches soient directement fixées (par exemple collées) à la carrure CR. L'anneau AN n'a pas à être un très bon conducteur thermique (un anneau en acier suffit), mais les branches BC doivent l'être : ainsi, elles sont avantageusement en cuivre, en argent, en or, en aluminium, ou en un alliage comportant ces matériaux comme base. Par ailleurs, dans le mode de réalisation de la figure 3, les branches BC sont au nombre de quatre, mais elles pourraient être plus ou moins nombreuses. La figure 4 montre un mode de réalisation dans lequel l'élément de support SP comporte trois branches BC.

Les branches BC sont flexibles pour amortir les chocs. Grâce à leur flexibilité, les branches peuvent se déformer lors d'un choc. En outre, elles conduisent la chaleur. La caractéristique de la conductance thermique C d'un élément de support à N branches identiques de longueur $l$ est donnée par la formule :

$$C = N * a * \frac{b}{l} * \lambda$$

, où $a$ est la largeur, b l'épaisseur des $N$ branches , et $\lambda$ la conductibilité thermique du matériau utilisé. La raideur mécanique K de l'élément de support à N branches est donnée par la formule , $K = N * E * a * \dfrac{b^3}{l^3}$, où E est le module d'élasticité du matériau utilisé.

Indépendamment les uns des autres, les paramètres appartiennent aux intervalles suivants : $N$ allant de 1 à 8, $a$ allant de 2 à 10 mm, b allant de 0.2 à 1.0 mm et $l$ allant de 10 à 25mm. Selon l'amortissement recherché, on choisit des paramètres pour obtenir une raideur K appartenant à l'intervalle allant de 0.15 N/mm à 2800 N/mm et une conductance thermique C allant de 6.7 à 840 mW/K.

De préférence, on choisit $N$ de 2 à 4 branches, $a$ allant de 4 à 6 mm, b allant de 0.45 à 0.55 mm et $l$ de 14 à 16 mm. Avantageusement, on cherche à obtenir une raideur K comprise entre 12.8 et 104.8 N/mm et une conductance thermique C comprises entre 47 et 198 mW/K.

Si on choisit un matériau comme l'aluminium de conductibilité thermique $\lambda$ = 210 W/m/K et de module d'élasticité E = 72 GPa, la conductance thermique C et la raideur mécanique K peuvent être adaptées dans un large domaine en variant les paramètres tels que le nombre N de branches, ainsi que leurs dimensions *a, b* et *l.*

Par exemple, pour deux branches, N = 2, ayant les dimensions suivantes : *l*= 14 mm, *a* = 5 mm et *b* =0.5 mm, on obtient C = 75 mW/K et *K* = 32,8 N/mm. Si on le souhaite, on peut augmenter la raideur d'environ 20% tout en maintenant la conductance thermique. Pour cela, on augmente l'épaisseur b de 10% et on diminue la largeur *a* de 10 % pour obtenir *a* = 4.5 mm, *b* = 0.55 mm, *C* = 74 mW/K et *K* = 39.3 N/mm.

Pour améliorer significativement la conductance thermique le long des branches, il est possible de coller sur les branches des films à base de graphite présentant des hautes conductibilités thermiques dans le plan de l'ordre de 400 W/m/K (par exemple le T62® de la société T-global®). Un tel film de 0.13 mm d'épaisseur et de 5mm de largeur est collé sur toute la longueur *l* des branches pour ajouter une conductance de 37 mW/K supplémentaire à celle d'une structure à 2 branches de largeur *a* = 5mm, d'épaisseur b =0.50 mm et de longueur *l* =14 mm, afin d'obtenir une conductance C de 112 mW/K au lieu de 75 mW/K.

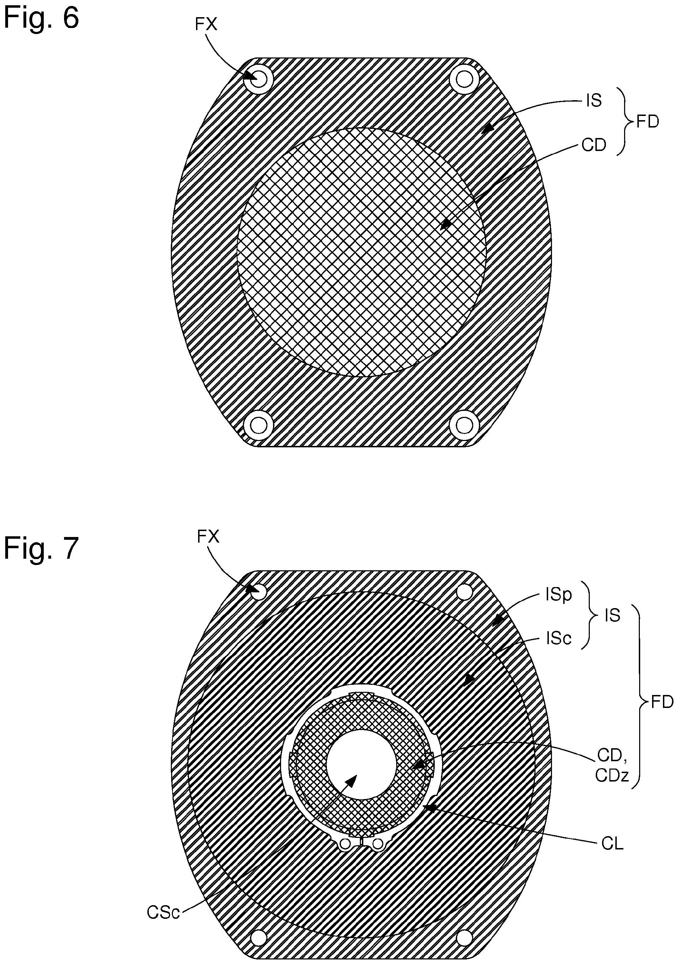

Le module thermoélectrique MT est positionné au niveau de l'extrémité commune EX1 des branches BC, la plaque froide PF étant directement ou indirectement en contact avec ladite extrémité commune EX1. Dans le cas où la plaque froide PF est indirectement en contact avec l'extrémité commune EX1 des branches BC, un coussinet CSf à grande conductibilité thermique et fort pouvoir amortisseur mécanique est positionné entre la plaque froide PF et l'extrémité commune EX1, comme cela est visible à la figure 5. Quant à la plaque chaude PC, elle est, elle-aussi, directement ou indirectement en contact avec le fond FD. Dans le cas où la plaque chaude PC est indirectement en contact avec le fond FD, un coussinet CSc à grande conductibilité thermique et fort pouvoir amortisseur mécanique est positionné entre la plaque chaude PC et le fond FD, ledit coussinet CSc étant visible sur la figure 7. Des coussinets de ce type peuvent être réalisés en élastomère chargé avec du verre, du carbone, du graphite ou du diamant.

Comme représenté aux figures 6 et 7, le fond FD est formé de deux parties : une partie thermiquement conductrice CD centrale et une partie thermiquement isolante IS. La partie isolante IS est elle-même formée de deux zones : une zone centrale ISc et une zone périphérique ISp. Du côté poignet (voir figure 6), la partie conductrice CD recouvre la zone centrale ISc de la partie isolante IS, et la zone périphérique ISp de la partie isolante IS entoure la partie conductrice CD. En outre, la zone centrale ISc de la partie isolante IS comporte une ouverture traversante (centrée, dans le mode de réalisation de la figure 7, mais qui pourrait alternativement être décentrée, en fonction de la position du module thermoélectrique), rendant une zone de la partie conductrice CD, dite zone de contact CDz, accessible depuis le côté module thermoélectrique. La zone de contact CDz est destinée à être en contact direct ou indirect avec le module thermoélectrique MT. Ainsi, une face de la partie conductrice CD est en contact avec le poignet lorsque la montre est portée, et le flux thermique traverse la partie conductrice CD et est amené au niveau de la zone de contact CDz pour être dirigé sur la plaque chaude PC du module thermoélectrique MT. La partie isolante IS, quant à elle, permet de limiter les flux thermiques entre le poignet et la carrure CR de la montre ne passant pas par le module thermoélectrique MT. En d'autres termes, le flux thermique est forcé à passer du fond FD à la carrure CR en passant par le module thermoélectrique MT.

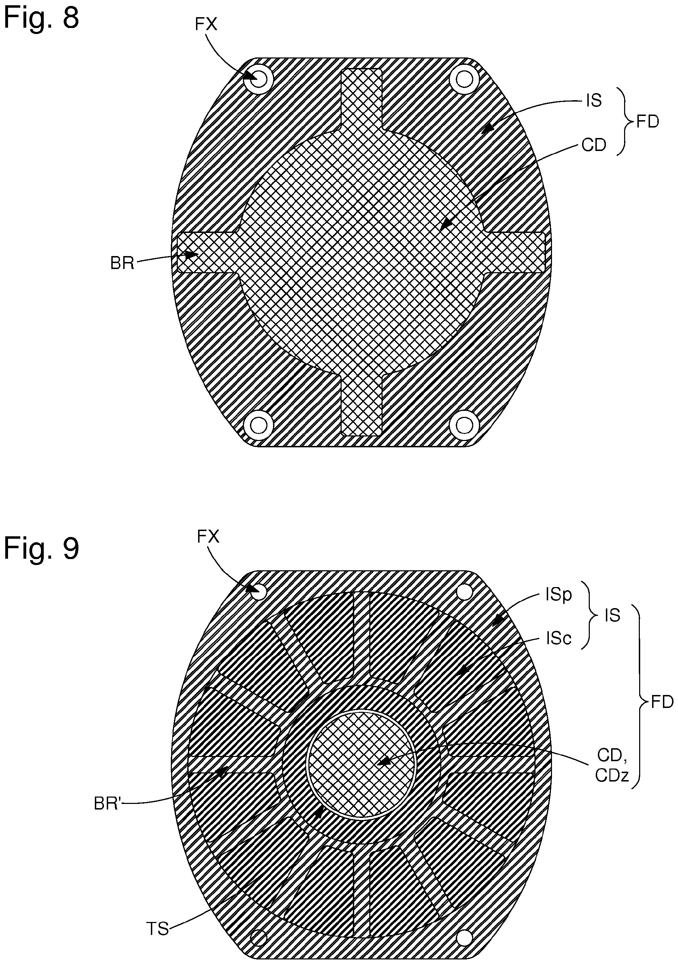

Dans le mode de réalisation de la figure 7, la partie conductrice CD est fixée à la partie isolante IS au niveau de la zone de contact CDz, au moyen d'un circlip CL. Alternativement, la partie conductrice CD pourrait être fixée à la partie isolante au niveau de la zone de contact CDz, au moyen d'un sertissage TS, comme c'est le cas du mode de réalisation montré à la figure 9.

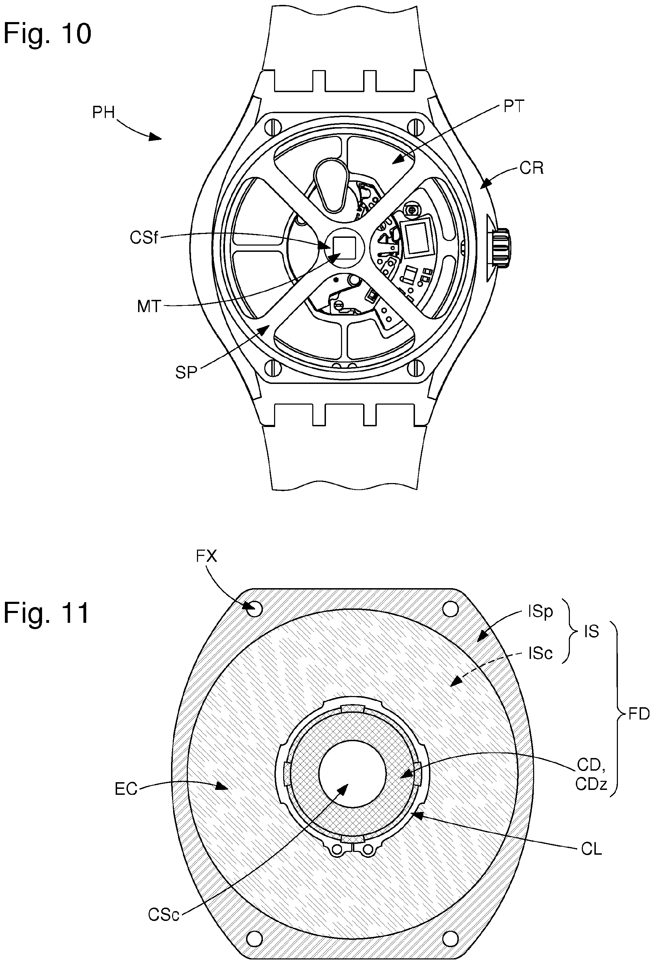

On remarque en outre que l'épaisseur de la zone centrale ISc de la partie isolante IS est inférieure à l'épaisseur de la zone périphérique ISp, de sorte que le fond FD ait un aspect creusé du côté module thermoélectrique. La zone périphérique ISp est destinée à être fixée à la carrure CR, elle comporte donc des trous de fixation FX et doit être solide, d'où son épaisseur. En revanche, du côté module thermoélectrique, la zone centrale ISc est en vis-à-vis des branches BC de l'élément de support SP. L'air étant meilleur isolant que n'importe quel matériau utilisé pour réaliser la partie isolante IS, il est préférable d'éloigner la zone centrale ISc des branches BC pour augmenter l'isolation. Le volume vide pourrait alternativement être rempli d'un gaz meilleur isolant que l'air, tel de l'argon. On note que le volume pourrait alternativement être rempli de mousse polyuréthane. En outre, pour augmenter ledit volume et ainsi améliorer l'isolation, il est avantageux de creuser la platine PT également, comme cela est visible aux figures 3 et 10.

La figure 8 montre une forme alternative de la partie conductrice CD, côté poignet. Dans ce mode de réalisation, la partie conductrice CD comporte des bras rigidifiés BR permettant de renforcer mécaniquement ladite zone centrale ISc, en particulier lorsque cette dernière est rendue fragile par sa faible épaisseur. Avantageusement, ces bras BR s'étendent radialement et viennent recouvrir la zone périphérique ISp de la partie isolante IS. Le renfort mécanique pourrait alternativement être réalisé au niveau de la zone centrale ISc elle-même, en surmontant la zone centrale ISc de bras BR' s'étendant radialement sur la face côté module thermoélectrique. La figure 9 illustre un tel mode de réalisation.

Par ailleurs, dans un mode de réalisation illustré à la figure 11, la montre PH comporte un écran thermique EC radiatif recouvrant la zone centrale ISc de la partie isolante IS côté module thermoélectrique, et permettant d'éviter les échanges thermiques par radiation entre le fond FD et l'élément de support SP. L'écran thermique EC est avantageusement réalisé de la même manière que les couvertures de survie, le côté aluminium étant tourné vers l'élément de support, le côté doré (en plastique) étant caché. L'écran EC est collé ou pincé sur sa périphérie entre le fond FD et la carrure CR. Etant donné que l'écran thermique EC comporte une face métallique, il fait également office d'écran de Faraday permettant de protéger la montre PH contre d'éventuelles décharges électrostatiques. L'écran thermique EC radiatif pourrait alternativement être réalisé par évaporation d'aluminium ou par application d'un spray sur la zone centrale ISc de la partie isolante IS, du côté module thermoélectrique.

Bien entendu, la présente invention ne se limite pas à l'exemple illustré mais est susceptible de diverses variantes et modifications qui apparaîtront à l'homme de l'art.

## Revendications

1. Montre thermoélectrique (PH), comprenant un module thermoélectrique (MT) comportant une plaque dite chaude (PC) et une plaque dite froide (PF) reliées par des piliers semi-conducteurs (PS), la plaque chaude (PC) étant connectée thermiquement avec le fond (FD) de la montre (PH), la plaque froide (PF) étant connectée thermiquement avec la carrure (CR) de la montre (PH) par l'intermédiaire d'un élément de support (SP), la montre étant **caractérisée en ce que** ledit élément de support (SP) comporte au moins deux branches (BC), les au moins deux branches (BC) ayant une extrémité commune (EX1) au niveau de laquelle est maintenue la plaque froide (PF) du module thermoélectrique (MT), les au moins deux branches (BC) étant flexibles et agencées pour amortir les chocs se propageant de la carrure au module thermoélectrique (MT).

2. Montre thermoélectrique (PH) selon la revendication précédente, l'élément de support (SP) comportant un anneau (AN) métallique passant par les autres extrémités des branches (BC), dites deuxièmes extrémités (EX2), et l'anneau (AN) est fixé à la carrure (CR) de sorte que les deuxièmes extrémités (EX2) sont solidaires de la carrure (CR) par l'intermédiaire de l'anneau (AN).

3. Montre thermoélectrique (PH) selon l'une des revendications précédentes, les branches (BC) étant de longueur similaire.

4. Montre thermoélectrique (PH) selon l'une des revendications précédentes, un coussinet (CSc) à grande conductibilité thermique et fort pouvoir amortisseur mécanique étant placé à l'interface entre le fond (FD) et le module thermoélectrique (MT).

5. Montre thermoélectrique (PH) selon l'une des revendications précédentes, un coussinet (CSf) à grande conductibilité thermique et fort pouvoir amortisseur mécanique est placé à l'interface entre le module thermoélectrique (MT) et l'élément de support (SP).

6. Montre thermoélectrique (PH) selon l'une des revendications précédentes, le fond (FD) comportant :

   - une partie en matériau thermiquement conducteur (CD) agencée de sorte à être en contact avec le poignet lorsque la montre (PH) est portée et à diriger un flux thermique depuis le poignet vers le module thermoélectrique (MT)
   - une partie en matériau thermiquement isolant (IS) agencée de sorte à limiter les flux thermiques entre le poignet et la carrure (CR) de la montre (PH) ne passant pas par le module thermoélectrique (MT).

7. Montre thermoélectrique (PH) selon la revendication précédente, la partie isolante (IS) comprenant une zone centrale (ISc) et une zone périphérique (ISp), la zone centrale (ISc) étant d'épaisseur plus faible que la zone périphérique (ISp).

8. Montre thermoélectrique (PH) selon la revendication 7, la zone centrale (ISc) de la partie isolante (IS), côté module thermoélectrique, étant surmontée de bras (BR') permettant de renforcer mécaniquement ladite zone centrale (ISc).

9. Montre thermoélectrique (PH) selon la revendication 7, la partie conductrice (CD), côté poignet, comportant des bras (BR) recouvrant localement la zone centrale (ISc) de la partie isolante (IS).

10. Montre thermoélectrique (PH) selon l'une des revendications 6 à 9, comprenant un écran radiatif (EC) thermique recouvrant la zone centrale (ISc) de la partie isolante (IS), côté module thermoélectrique.

11. Montre thermoélectrique (PH) selon l'une, quelconque, des revendications précédentes, dans laquelle la raideur mécanique K de l'élément de support (SP) est comprise dans un intervalle allant de 0.15 N/mm à 2800 N/mm, de préférence allant de 12.8 N/mm à 104.8 N/mm.

12. Montre thermoélectrique (PH) selon l'une, quelconque, des revendications précédentes, dans laquelle la conductance thermique C de l'élément de support (SP) est comprise dans un intervalle allant de 6.7 à 840 mW/K, de préférence allant de 47 et 198 mW/K.

13. Montre thermoélectrique (PH) selon l'une, quelconque, des revendications précédentes, dans laquelle l'élément de support (SP) comprend des films à base de graphite collés sur les branches (BC), les films présentant de préférence des conductibilités thermiques d'au moins 400 W/m/K.

14. Montre thermoélectrique (PH) selon l'une, quelconque, des revendications précédentes, dans laquelle les au moins deux branches (BC) sont en aluminium.

**Patentansprüche**

1. Thermoelektrische Uhr (PH), umfassend ein thermoelektrisches Modul (MT), welches eine sogenannte heiße Platte (PC) und eine sogenannte kalte Platte (PF) beinhaltet, welche durch Halbleitersäulen (PS) verbunden sind, wobei die heiße Platte (PC) thermisch an den Boden (FD) der Uhr (PH) angeschlossen ist, die kalte Platte (PF) thermisch über ein Stützelement (SP) an den Mittelteil (CR) der Uhr (PH) angeschlossen ist, wobei die Uhr **dadurch gekennzeichnet ist, dass** das Stützelement (SP) mindestens zwei Arme (BC) beinhaltet, wobei die mindestens zwei Arme (BC) ein gemeinsames Ende (EX1) aufweisen, im Bereich dessen die kalte Platte (PF) des thermoelektrischen Moduls (MT) gehalten wird, wobei die mindestens zwei Arme (BC) flexibel und so angeordnet sind, um Stöße zu dämpfen, die sich von dem Mittelteil zu dem thermoelektrischen Modul (MT) ausbreiten.

2. Thermoelektrische Uhr (PH) nach dem vorstehenden Anspruch, wobei das Stützelement (SP) einen Metallring (AN) beinhaltet, der durch die anderen Enden der Arme (BC), die sogenannten zweiten Enden (EX2), verläuft, und der Ring (AN) an dem Mittelteil (CR) befestigt ist, so dass die zweiten Enden (EX2) anhand des Ringes (AN) fest mit dem Mittelteil (CR) verbunden sind.

3. Thermoelektrische Uhr (PH) nach einem der vorstehenden Ansprüche, wobei die Arme (BC) von ähnlicher Länge sind.

4. Thermoelektrische Uhr (PH) nach einem der vorstehenden Ansprüche, wobei an der Schnittstelle zwischen dem Boden (FD) und dem thermoelektrischen Modul (MT) ein Lager (CSc) mit hoher Wärmeleitfähigkeit und starkem mechanischen Dämpfungsvermögen platziert ist.

5. Thermoelektrische Uhr (PH) nach einem der vorstehenden Ansprüche, wobei an der Schnittstelle zwischen dem thermoelektrischen Modul (MT) und dem Stützelement (SP) ein Lager (CSf) mit hoher Wärmeleitfähigkeit und starkem mechanischen Dämpfungsvermögen platziert ist.

6. Thermoelektrische Uhr (PH) nach einem der vorstehenden Ansprüche, wobei der Boden (FD) beinhaltet:

   - einen Teil aus wärmeleitendem Werkstoff (CD), der so angeordnet ist, um mit dem Handgelenk in Berührung zu sein, wenn die Uhr (PH) getragen wird, und einen Wärmefluss von dem Handgelenk zu dem thermoelektrischen Modul (MT) zu leiten
   - einen Teil aus thermisch isolierendem Werkstoff (IS), der so angeordnet ist, um die Wärmeflüsse zwischen dem Handgelenk und dem Mittelteil (CR) der Uhr (PH), der nicht durch das thermoelektrische Modul (MT) verläuft, zu begrenzen.

7. Thermoelektrische Uhr (PH) nach dem vorstehenden Anspruch, wobei der isolierende Teil (IS) einen zentralen Bereich (ISc) und einen peripheren Bereich (ISp) umfasst, wobei der zentrale Bereich (ISc) von geringerer Dicke als der periphere Bereich (ISp) ist.

8. Thermoelektrische Uhr (PH) nach Anspruch 7, wobei der zentrale Bereich (ISc) des isolierenden Teils (IS) auf Seiten des thermoelektrischen Moduls von Armen (BR') überragt wird, die es ermöglichen, den zentralen Bereich (ISc) mechanisch zu verstärken.

9. Thermoelektrische Uhr (PH) nach Anspruch 7, wobei der leitende Teil (CD) auf Seiten des Handgelenks Arme (BR) beinhaltet, welche den zentralen Bereich (ISc) des isolierenden Teils (IS) lokal abdecken.

10. Thermoelektrische Uhr (PH) nach einem der Ansprüche 6 bis 9, einen thermischen Strahlungsschirm (EC) umfassend, welcher den mittleren Bereich (ISc) des isolierenden Teils (IS) auf Seiten des thermoelektrischen Moduls abdeckt.

11. Thermoelektrische Uhr (PH) nach einem der vorstehenden Ansprüche, wobei die mechanische Steifheit K des Stützelements (SP) in einem Intervall inbegriffen ist, welches von 0,15 N/mm bis 2.800 N/mm, vorzugsweise von 12,8 N/mm bis 104,8 N/mm reicht.

12. Thermoelektrische Uhr (PH) nach einem der vorstehenden Ansprüche, wobei der thermische Leitwert C des Stützelements (SP) in einem Intervall inbegriffen ist, welches von 6,7 bis 840 mW/K, vorzugsweise von 47 bis 198 mW/K reicht.

13. Thermoelektrische Uhr (PH) nach einem der vorstehenden Ansprüche, wobei das Stützelement (SP) Filme auf Basis von Graphit umfasst, die auf die Arme (BC) geklebt sind, wobei die Filme vorzugsweise Wärmeleitfähigkeiten von mindestens 400 W/m/K aufweisen.

**14.** Thermoelektrische Uhr (PH) nach einem der vorstehenden Ansprüche, wobei die mindestens zwei Arme (BC) aus Aluminium sind.

## Claims

**1.** Thermoelectric watch (PH) comprising a thermoelectric module (MT) including a hot plate (PC) and a cold plate (PF) connected by semiconductor pillars (PS), wherein the hot plate (PC) is thermally connected to the back cover (FD) of the watch (PH), the cold plate (PF) is thermally connected to the case middle (CR) of the watch (PH) via a support element (SP), the watch being **characterized in that** said support element includes at least two branches (BC), the at least two branches (BC) have a common end (EX1) on which is held the cold plate (PF) of the thermoelectric module (MT), and the at least two branches (BC) being flexible and arranged to absorb shocks propagating from the case middle to the thermoelectric module (MT).

**2.** Thermoelectric watch (PH) according to the preceding claim, wherein the support element (SP) includes a metal ring (AN) that passes through the other ends of the branches (BC) called the second ends (EX2), and the ring (AN) is fixed to the case middle (CR) such that the second ends (EX2) are joined to the case middle (CR) via the ring (AN).

**3.** Thermoelectric watch (PH) according to any of the preceding claims, wherein the branches (BC) are of similar length.

**4.** Thermoelectric watch (PH) according to any of the preceding claims, wherein a bearing (CSc) with high thermal conductivity and high mechanical damping is placed at the interface between the back cover (FD) and the thermoelectric module (MT).

**5.** Thermoelectric watch (PH) according to any of the preceding claims, wherein a bearing (CSc) with high thermal conductivity and high mechanical damping is placed at the interface between the thermoelectric module (MT) and the support element (SP).

**6.** Thermoelectric watch (PH) according to any of the preceding claims, wherein the back cover (FD) includes:

> - a part made of thermally conductive material (CD) arranged to be in contact with the wrist when the watch (PH) is worn and to direct a heat flux from the wrist towards the thermoelectric module (MT)
>
> - a part made of thermally insulating material (IS) arranged to limit heat fluxes between the wrist and case middle (CR) of the watch (PH) that do not pass through thermoelectric module (MT).

**7.** Thermoelectric watch (PH) according to the preceding claim, wherein the insulating part (IS) includes a central area (ISc) and a peripheral area (ISp), the central area (ISc) having a smaller thickness than the peripheral area (ISp).

**8.** Thermoelectric watch (PH) according to claim 7, wherein the central area (ISc) of the insulating part (IS), on the thermoelectric module side, is surmounted by arms (BR') in order to mechanically reinforce said central area (ISc).

**9.** Thermoelectric watch (PH) according to claim 7, wherein the conductive part (CD), on the wrist side, includes arms (BR) locally covering the central area (ISc) of the insulating part (IS).

**10.** Thermoelectric watch (PH) according to any of claims 6 to 9, wherein the watch includes a heat radiation screen (EC) covering the central area (ISc) of the insulating part (IS), on the thermoelectric module side.

**11.** Thermoelectric watch (PH) according to any of the preceding claims, wherein the mechanical stiffness K of the support element (SP) is within a range of between 0.15 N/mm and 2800 N/mm, preferably between 12.8 N/mm and 104.8 N/mm.

**12.** Thermoelectric watch (PH) according to any of the preceding claims, wherein the thermal conductance C of the support element (SP) is within a range of between 6.7 and 840 mW/K, preferably between 47 and 198 mW/K.

**13.** Thermoelectric watch (PH) according to any of the preceding claims, wherein the support element (SP) includes graphite-based films bonded to the branches (BC) and the films preferably have thermal conductivities of at least 400 W/m/K.

**14.** Thermoelectric watch (PH) according to any of the preceding claims, wherein the at least two branches (BC) are made of aluminium.

## Fig. 1

## Fig. 2

# Fig. 3

# Fig. 4

# Fig. 5

Fig. 6

Fig. 7

Fig. 8

Fig. 9

**Fig. 10**

**Fig. 11**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 1043781 A1

- US 2003007424 A1